# EUROPEAN PATENT APPLICATION

(11) **EP 4 823 255 A1**
(43) Date of publication of application: **14.10.2026**
(21) Application number: 24900077.9
(22) Date of filing: 19.11.2024
(51) Int. Cl.: H05K 7/20, G06F 1/20

(54) **PASSIVE LIQUID COOLING SYSTEM, CHIP AND ELECTRONIC APPARATUS**

(30) Priority: 07.12.2023 CN 202311677924
(71) Applicant: Cloud Intelligence Assets Holding (Singapore) Private Limited, Singapore 189554 (SG)
(72) Inventor: ZHU, Fangbo, Hangzhou City, Zhejiang 310030 (CN); YAO, Zhiping, Sunnyvale, California 94085 (US); HUANG, Yiyuan, Hangzhou City, Zhejiang 310030 (CN); CHEN, Liang, Hangzhou City, Zhejiang 310030 (CN); DU, Wei, Hangzhou City, Zhejiang 310030 (CN); SUN, Yuhai, Hangzhou City, Zhejiang 310030 (CN); CHEN, Mingxuan, Hangzhou City, Zhejiang 310030 (CN)
(74) Representative: Novagraaf Technologies
(86) International application number: PCT/IB2024/061540
(87) International publication number: WO 2025/120430

(57) **Abstract**

Embodiments of the present disclosure provide a passive liquid cooling system, a board, and an electronic device. The passive liquid cooling system is an indirect-contact heat dissipation solution that does not rely on a circulation pump, and in addition, is also a solution that performs heat dissipation through two-layer (or two-stage) liquid phase transition. Because the system does not rely on the circulation pump, various technical problems caused by the circulation pump can be resolved. For example, the entire passive liquid cooling system is not limited by a service life of the circulation pump, eliminating a need to perform operation and maintenance on the circulation pump. In addition, the two-layer liquid phase transition is used for heat dissipation, featuring high heat dissipation performance, so that a heat dissipation requirement of a high-power device can be satisfied.

## Description

### TECHNICAL FIELD

This application relates to the technical field of liquid cooling, and in particular, to a passive liquid cooling system, a board, and an electronic device.

### BACKGROUND

With development of chip technologies, functions of chips become more powerful, leading to a consequent power increase. For example, for an exchange chip, power of a 51.2 T single chip is nearly 800 w (watt), and a heat flow density is approximately 100 w/cm² (watt per square centimeter). For a chip, an operating temperature of the chip is usually reduced by using a heat dissipation technology.

Currently, a mainstream heat dissipation technology is a liquid cooling technology. However, in a current liquid cooling technology, heat dissipation relies on a circulation pump driving liquid to flow through a cold plate, which is affected by the circulation pump and relies on an overall planning of an internet data center (Internet Data Center, IDC), resulting in high costs for implementation, operation, and maintenance. Alternatively, heat dissipation relies on phase transition by immersing the chip in liquid, which interferes with some signals and fails to be widely implemented. Therefore, a new liquid cooling solution is needed.

### SUMMARY

A plurality of aspects of the present disclosure provide a passive liquid cooling system, a board, and an electronic device, to provide a new liquid cooling solution.

An embodiment of the present disclosure provides a passive liquid cooling system, including: a first cavity, filled with first liquid capable of phase transition; a heat dissipation apparatus, disposed through the first cavity, where the heat dissipation apparatus includes: a second cavity, an evaporation end and a condensation end, the evaporation end and the condensation end communicate with the second cavity, and the second cavity is filled with second liquid capable of phase transition; where an outer side of the evaporation end is configured to contact a heat-generating component, and cause the second liquid to undergo phase transition into second vapor when absorbing heat; and an outer side of the condensation end is in contact with the first liquid, and is configured to diffuse heat into the first liquid to cause the first liquid to undergo phase transition into first vapor, and cause the second vapor to be condensed to fall back into the second cavity when encountering with the second vapor; and a condensing apparatus, disposed on the first cavity, and configured to condense the first vapor to fall back into the first cavity when encountering with the first vapor.

An embodiment of the present disclosure further provides a board, the board includes a chip, at least one of the board and the chip is mounted with the foregoing passive liquid cooling system.

An embodiment of the present disclosure further provides an electronic device, the electronic device includes a board, the board includes a chip, at least one of the electronic device, the board, and the chip is mounted with the foregoing passive liquid cooling system.

An embodiment of the present disclosure provides a new passive liquid cooling system. The passive liquid cooling system belongs to a liquid cooling technology in a large technical scope, but different from a conventional cold-plate liquid cooling solution and a conventional immersion liquid cooling solution, the passive liquid cooling system is an entirely new liquid cooling solution. The passive liquid cooling system provided in this embodiment of the present disclosure is an indirect-contact heat dissipation solution that does not rely on a circulation pump, and in addition, is also a solution that performs heat dissipation through two-layer (or two-stage) liquid phase transition. Because the system does not rely on the circulation pump, various technical problems caused by the circulation pump are solved. For example, the entire passive liquid cooling system is not limited by a service life of the circulation pump, eliminating a need to perform operation and maintenance on the circulation pump. Deployment and implementation also do not rely on an overall planning of an IDC, making implementation straightforward and enabling comprehensive rollout and implementation of the passive liquid cooling system in various equipment rooms.

In addition, the two-layer liquid phase transition is used for heat dissipation, featuring high heat dissipation performance, so that a heat dissipation requirement of a high-power device is satisfied. For example, the passive liquid cooling system is applicable to performing heat dissipation on various exchange chips with large exchange capacities, such as a 51.2 T exchange chip.

Moreover, because of indirect-contact heat dissipation, a chip or a device is not immersed in liquid any more, which not only addresses problems caused by the circulation pump and the heat dissipation requirement of the high-power device, but also addresses a problem of liquid interference with an electrical signal or an optical signal, making the passive liquid cooling system universally applicable. The passive liquid cooling system provided in this embodiment of the present disclosure is applicable to heat dissipation for various chips including an optical signal module and some chips that includes an optical signal module.

### BRIEF DESCRIPTION OF THE DRAWINGS

The accompanying drawings described herein are used to provide a further understanding of the present disclosure, and form part of the present disclosure. The illustrative embodiments of the present disclosure and descriptions thereof are used to explain the present disclosure, and do not constitute any undue limitation to the present disclosure. In the accompanying drawings:
FIG. 1 is a schematic structural diagram of a conventional cold-plate liquid cooling heat dissipation system;
FIG. 2 is a schematic structural diagram of a conventional single-phase liquid cooling system;
FIG. 3 is a schematic structural diagram of a conventional dual-phase immersion liquid cooling system;
FIG. 4 is a schematic structural diagram of a passive liquid cooling system according to an embodiment of the present disclosure; and
FIG. 5 is a diagram of an application scenario according to an embodiment of the present disclosure.

### DETAILED DESCRIPTION

To clearly state the objectives, technical solutions, and advantages of the present disclosure, the technical solutions of the present disclosure will be clearly and completely described below with reference to specific embodiments of the present disclosure and the accompanying drawings. Apparently, the described embodiments are some embodiments rather than all the embodiments of the present disclosure. All other embodiments obtained by a person of ordinary skill in the art based on the embodiments of the present disclosure without creative efforts shall fall within the protection scope of the present disclosure.

It should be noted that, user information (including, but not limited to, user equipment information, user personal information, and the like) and data (including, but not limited to, data for analysis, stored data, displayed data, and the like) involved in the present disclosure are information and data that have been authorized by users or that have been sufficiently authorized by all relevant parties. Related data needs to be collected, used, and processed in accordance with related laws and regulations and standards of related countries and regions, and a corresponding operation entry is provided for users to select to grant or deny authorization.

An embodiment of the present disclosure provides a passive liquid cooling system, which belongs to a liquid cooling technology in a large technical scope, but is different from various existing liquid cooling solutions. The liquid cooling technology is a heat dissipation technology in which liquid is used as a cooling medium (briefly referred to as a coolant) to transfer heat generated by a heat-generating component to the outside, to cool the heat-generating component, thereby ensuring safe operation of the heat-generating component or a chip or an IT device in which the heat-generating component is located.

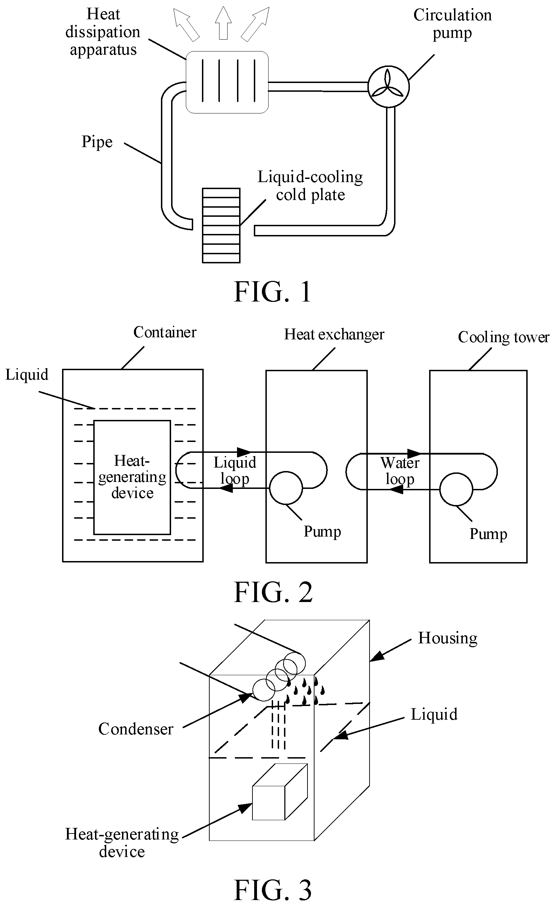

Currently, existing liquid cooling solutions include two types: cold-plate liquid cooling and immersion liquid cooling. The immersion liquid cooling is further divided into single-phase immersion liquid cooling and dual-phase immersion liquid cooling. The cold-plate liquid cooling is a heat dissipation technology in which a liquid-cooling cold plate is fixed to the heat-generating component, and a circulation pump drives liquid to flow through the cold plate, thereby removing the heat from the heat-generating component. FIG. 1 is a schematic structural diagram of a conventional cold-plate liquid cooling heat dissipation system. Referring to FIG. 1, the cold-plate liquid cooling heat dissipation system includes a heat dissipation apparatus, a liquid-cooling cold plate, pipes, and a circulation pump. Liquid flowing out of the circulation pump flows into the liquid-cooling cold plate through one of the pipes, the liquid flowing into the liquid-cooling cold plate absorbs the heat from the heat-generating component, the liquid absorbing the heat flows out of the liquid-cooling cold plate and flows into the heat dissipation apparatus through one of the pipes, and the liquid cooled by the heat dissipation apparatus flows into the circulation pump through one of the pipes again. The cold-plate liquid cooling needs a pump and regular liquid replenishment, has a high operation and maintenance requirement, and needs to be planned in advance by an IDC.

Single-phase liquid cooling is a heat dissipation technology in which a chip or a device in which a heat-generating component is located is immersed in liquid, and the liquid absorbs heat from the heat-generating component. Cooling liquid of the single-phase liquid cooling usually has a high boiling point. After absorbing the heat, the cooling liquid does not undergo phase transition and remains in a liquid state. FIG. 2 is a schematic structural diagram of a conventional single-phase liquid cooling system. Referring to FIG. 2, the single-phase liquid cooling system includes a container, a heat exchanger, and a cooling tower. The container holds liquid, a heat-generating component is immersed in the liquid, and the liquid in the container absorbs heat from the heat-generating component. The container and the heat exchanger perform heat exchange through a liquid loop, liquid in the liquid loop is circulated by a pump. The heat exchanger and the cooling tower perform heat exchange through a water loop, and water in the water loop is circulated by a pump. However, in this heat dissipation solution, the heat-generating component needs to be directly immersed in the liquid, and the pumps and regular liquid replenishment are also needed. Direct immersion affects performance of the heat-generating component. Using an example in which the heat-generating component is an exchange plate, transmission of an optical signal, especially a high-speed optical signal, of an optical module on the directly immersed exchange plate poses technical risks. In addition, single-phase immersion liquid cooling, like a cold-plate liquid cooling solution, needs the pumps and regular liquid replenishment, has a high operation and maintenance requirement, and needs to be planned in advance by an IDC.

Dual-phase immersion liquid cooling is a technology in which a chip or a device in which a heat-generating component is located is immersed in liquid, the liquid absorbs heat from the heat-generating component to undergo phase transition (which mainly refers to vaporization), and heat dissipation is performed through a phase transition process. FIG. 3 is a schematic structural diagram of a conventional dual-phase immersion liquid cooling system. Referring to FIG. 3, the dual-phase immersion liquid cooling system includes a housing and a condenser disposed in the housing. A heat-generating component is immersed in liquid, the liquid absorbs heat from the heat-generating component and undergoes phase transition, to generate vapor. The vapor rises and encounters the condenser. The condenser condenses the vapor, and condensed water drips toward a bottom of the housing under a force of gravity. Compared with single-phase immersion liquid cooling, dual-phase immersion liquid cooling does not need pumps and enables long-term sealing without being opened. Theoretically, regular liquid replenishment is not needed. However, like the single-phase immersion liquid cooling, the heat-generating component needs to be immersed in the liquid, and direct immersion affects performance of the heat-generating component. Using an example in which the heat-generating component is an exchange plate, transmission of an optical signal, especially a high-speed optical signal, of an optical module on the directly immersed exchange plate poses technical risks.

It can be known from the foregoing analysis that, both the cold-plate liquid cooling and the single-phase immersion liquid cooling rely on the circulation pumps. On the one hand, both the cold-plate liquid cooling and the single-phase immersion liquid cooling are limited by a service life of the circulation pumps. On the other hand, deployment of the circulation pumps and cooling pipelines depends on an overall planning of the IDC, resulting in high costs for implementation, operation, and maintenance. The dual-phase immersion liquid cooling no longer relies on the circulation pumps, but it requires the entire chip to be immersed in the liquid. The liquid greatly interferes with an electrical signal or an optical signal, and as a result, the dual-phase immersion liquid cooling is not universally applicable. Particularly, it is difficult to introduce the dual-phase immersion liquid cooling solution to some chips including an optical signal module and some future chips that include optical signal modules.

Through technological innovation in a liquid cooling technology, the inventor of the technical solution of the present disclosure provides a new passive liquid cooling system. The passive liquid cooling system belongs to the liquid cooling technology in a large technical scope, but different from a conventional cold-plate liquid cooling solution and a conventional immersion liquid cooling solution, the passive liquid cooling system is an entirely new liquid cooling solution. The passive liquid cooling system provided in this embodiment of the present disclosure is an indirect-contact heat dissipation solution that does not rely on a circulation pump, and in addition, is also a solution that performs heat dissipation through two-layer (or two-stage) liquid phase transition. Because the system does not rely on the circulation pump, various technical problems caused by the circulation pump are resolved. For example, the entire passive liquid cooling system is not limited by a service life of the circulation pump, eliminating a need to perform operation and maintenance on the circulation pump. Deployment and implementation also do not rely on an overall planning of an IDC, making implementation straightforward and enabling comprehensive rollout and implementation of the passive liquid cooling system in various equipment rooms. In addition, the two-layer liquid phase transition is used for heat dissipation, featuring high heat dissipation performance, so that a heat dissipation requirement of a high-power device is satisfied. For example, the passive liquid cooling system is applicable to performing heat dissipation on various exchange chips with large exchange capacities, such as a 51.2 T exchange chip. Moreover, because of indirect-contact heat dissipation, a chip or a device is not immersed in liquid any more, which not only addresses problems caused by the circulation pump and the heat dissipation requirement of the high-power device, but also addresses a problem of liquid interference with an electrical signal or an optical signal, making the passive liquid cooling system provided in this embodiment of the present disclosure universally applicable. The passive liquid cooling system provided in this embodiment of the present disclosure is applicable to heat dissipation for various chips including an optical signal module and some future chips that include an optical signal module.

It should be noted that this embodiment of the present disclosure do not limit a communication technology used by the optical signal module. Examples include, but are not limited to, a 112G PAM4 technology or a future 224G PAM4 technology. PAM4 (Pulse Amplitude Modulation 4-level) is a digital modulation technology, which uses four different pulse amplitude levels in each symbol period to represent data. 112G PAM4 refers to a standard that uses a PAM4 technology to perform data communication when a data transmission rate is 112Gbps (where 1Gbps equals 1000 megabits per second). Correspondingly, 224G PAM4 refers to a standard that uses the PAM4 technology to perform data communication when the data transmission rate is 224Gbps. These communication standards are usually used in high-speed data centers and communication networks, to provide a higher data transmission rate and greater bandwidth.

The following describes the technical solution provided in each embodiment of the present disclosure in detail with reference to the accompanying drawings.

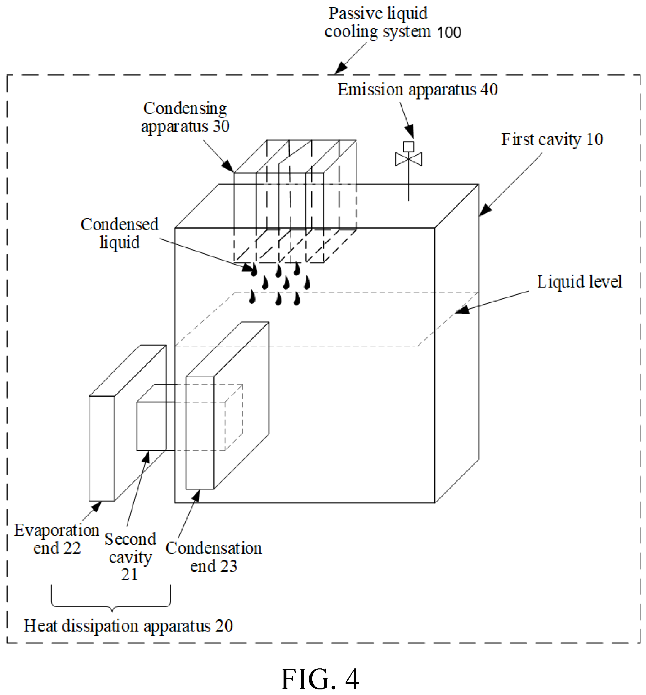

FIG. 4 is a schematic structural diagram of a passive liquid cooling system according to an embodiment of the present disclosure. As shown in FIG. 4, the passive liquid cooling system 100 includes: a first cavity 10, a heat dissipation apparatus 20, and a condensing apparatus 30.

In this embodiment, the first cavity 10 is filled with first liquid capable of phase transition. Specifically, the first cavity 10 is a cavity structure of any shape, for example, a cube, a cuboid, or a hexahedron. The first cavity 10 has an accommodating space, so that an interior of the first cavity 10 is filled with liquid. Herein, the liquid capable of phase transition filled in the interior of the first cavity 10 is referred to as the first liquid. The first liquid capable of phase transition means that the first liquid turns into vapor after absorbing a certain amount of heat. The first liquid is any liquid with a low boiling point. The liquid with a low boiling point refers to liquid with a boiling point below a preset temperature. The preset temperature is set flexibly as required, for example, the preset temperature is 30°C, or 40°C, or 50°C. For example, the first liquid includes, but is not limited to, liquid mixture of water and ethylene glycol, liquid mixture of water and propylene glycol, silicon oil, and fluorocarbon. Optionally, a first liquid injection port is further disposed on the first cavity, and is configured to inject the first liquid into the first cavity. In this way, when the first liquid in the first cavity decreases over time, some first liquid is re-injected, making the passive liquid cooling system more reliable in operation. It is noted herein that in this embodiment of the present disclosure, the first cavity provides a relatively sealed environment for the internal first liquid. In this way, leakage of the first liquid or the first liquid in a vaporized state is reduced, facilitating extending a service life of the entire passive liquid cooling system. Optionally, the first cavity is a fully sealed structure. Certainly, the first cavity alternatively has necessary ports, for example, liquid injection ports mentioned in subsequent embodiments. In a normal operating state, these ports are in a sealed state.

In this embodiment, the heat dissipation apparatus 20 is disposed through the first cavity. It should be understood that a part of the heat dissipation apparatus 20 extends through and out of the first cavity. In this way, a heat-generating component contacts the heat dissipation apparatus 20 for heat dissipation, and does not need to be immersed in the liquid. A mounting location of the heat dissipation apparatus 20 on the first cavity is not limited. Optionally, the heat dissipation apparatus is disposed on a side wall of the first cavity or disposed at a bottom of the first cavity. In this way, a part of the heat dissipation apparatus located inside the first cavity is entirely or partially immersed in the liquid, thereby improving heat dissipation performance of the heat dissipation apparatus. Optionally, the heat dissipation apparatus is disposed in a middle region or a lower region of the side wall of the first cavity, to further improve the heat dissipation performance of the heat dissipation apparatus.

Optionally, the mounting location of the heat dissipation apparatus 20 on the first cavity is determined based on a liquid level of the first liquid in the first cavity, so that the part of the heat dissipation apparatus located inside the first cavity is entirely immersed in the first liquid, to improve the heat dissipation performance of the heat dissipation apparatus.

Optionally, with an objective of making an air pressure value inside the first cavity meet a safe air pressure condition, controlling a distance between the liquid level of the first liquid in the first cavity and a top of the first cavity. The safe air pressure condition is flexibly set as required. For example, if the air pressure value inside the first cavity is less than the flexibly set safe air pressure value, the safe air pressure condition is satisfied. It should be understood that, after the first liquid is vaporized into the vapor by absorbing the heat, if the distance between the liquid level of the first liquid in the first cavity and the top of the first cavity is short, air pressure inside the first cavity is excessively large, easily affecting the service life of the first cavity. Therefore, when the first liquid is injected into the first cavity, it is necessary to control the distance between the liquid level of the first liquid in the first cavity and the top of the first cavity.

Optionally, a volume of the first cavity and a volume of the first liquid are determined in advance based on a type, an application scenario, and/or power of the heat-generating component employing the passive liquid cooling system. For example, when the heat-generating component is different types of chips such as an exchange chip, a CPU (Central Processing Unit) chip, or a power supply chip, a ratio of the volume of the first cavity to the volume of the first liquid varies. For example, in different types of scenarios such as an e-commerce scenario, a short video scenario, or a big data calculation scenario, the heat generated by the heat-generating component varies, so that the ratio of the volume of the first cavity to the volume of the first liquid varies accordingly. For example, a difference in power between a 25.6 T exchange chip and a 51.2 T exchange chip leads to a difference in heat generation, so that the ratio of the volume of the first cavity to the volume of the first liquid varies accordingly.

In this embodiment, the heat dissipation apparatus 20 includes: a second cavity 21, an evaporation end 22 and a condensation end 23. The evaporation end 22 and the condensation end 23 communicate with the second cavity 21. The second cavity 21 is filled with second liquid capable of phase transition, where an outer side of the evaporation end 22 is configured to contact the heat-generating component, and cause the second liquid to undergo phase transition into second vapor when absorbing the heat; and an outer side of the condensation end 23 is in contact with the first liquid, and is configured to diffuse heat into the first liquid to cause the first liquid to undergo phase transition into first vapor and cause the second vapor to be condensed to fall back into the second cavity when encountering with the second vapor.

In the embodiment, the second cavity 21 is a cavity structure of any shape, for example, the cube, the cuboid, or the hexahedron. Optionally, when the heat dissipation apparatus 20 is disposed on the side wall of the first cavity, the second cavity has a hollow rectangular cavity structure. In this way, a heat dissipation effect is improved. The second cavity 21 has an accommodating space, so that an interior of the second cavity 21 is filled with liquid. Herein, the liquid capable of phase transition filled in the interior of the second cavity 21 is referred to as second liquid. The second liquid capable of phase transition means that the second liquid turns into vapor after absorbing a certain amount of heat. The second liquid is any liquid with a low boiling point, which includes, but is not limited to, the liquid mixture of water and ethylene glycol, the liquid mixture of water and propylene glycol, the silicon oil, and the fluorocarbon. Similarly, in this embodiment of the present disclosure, the second cavity provides a relatively sealed environment for the internal second liquid. In this way, leakage of the second liquid or the second liquid in a vaporized state is reduced, facilitating extending the service life of the entire passive liquid cooling system. Optionally, the second cavity is a fully sealed structure. Certainly, the second cavity alternatively has necessary ports, for example, liquid injection ports mentioned in subsequent embodiments. In a normal operating state, these ports are in a sealed state.

In this embodiment, a shape of the evaporation end 22 is not limited, and is, for example, a plate-shaped structure or a column-shaped structure. The evaporation end 22 has a heat conduction function. When the outer side of the evaporation end 22 is in contact with the heat-generating component, the heat from the heat-generating component is absorbed by the evaporation end 22. The heat absorbed by the evaporation end 22 is conducted to the second liquid in the second cavity 21. After absorbing the heat, the second liquid undergoes phase transition and turns into the vapor. The vapor is referred to as the second vapor herein.

Optionally, an area of a surface of the evaporation end 22 in contact with the heat-generating component is smaller than an area of a surface of the evaporation end 22 in contact with the second cavity 21. In this way, relatively speaking, the evaporation end 22 rapidly absorbs the heat from the heat-generating component, thereby ensuring the service life of the heat-generating component, and in addition, further rapidly conducts the absorbed heat from the heat-generating component to the second liquid in the second cavity 21, thereby accelerating the heat dissipation effect of the heat dissipation apparatus 20.

In this embodiment, a shape of the condensation end 23 is not limited, and is, for example, the plate-shaped structure or the column-shaped structure. Optionally, the condensation end 23 is of an arc-shaped plate structure, to increase a contact area between the condensation end 23 and the first liquid, thereby improving the overall heat dissipation effect. The condensation end 23 has the heat conduction function. When the second vapor encounters with the condensation end 23, the condensation end 23 absorbs the heat from the second vapor, and the second vapor after the heat is absorbed is condensed into liquid and falls back into the second cavity. The heat absorbed by the condensation end 23 from the second vapor is conducted to the first liquid, and the first liquid after absorbing the heat undergoes the phase transition and turns into the vapor. The vapor is referred to as the first vapor herein.

Optionally, an area of a surface of the condensation end 23 in contact with the second cavity 21 is smaller than an area of a surface of the condensation end 23 in contact with the first liquid. In this way, relatively speaking, the condensation end 23 rapidly absorbs the heat from the second vapor, and in addition, further rapidly conducts the absorbed heat to the first liquid, thereby accelerating the heat dissipation effect of the heat dissipation apparatus 20.

Optionally, the heat dissipation apparatus 20 further includes a second liquid injection port, and the second liquid injection port communicates with the second cavity. The second liquid injection port is configured to inject the second liquid into the second cavity. In this way, the second liquid in the second cavity is replenished or replaced at any time, making the passive liquid cooling system 100 more reliable in operation.

In this embodiment, a boiling point of the first liquid and a boiling point of the second liquid are not limited. Optionally, the boiling point of the first liquid is lower than the boiling point of the second liquid. In an actual application, heat loss occurs during a transfer by the second liquid. The first liquid has a lower boiling point, so that the first liquid conducts the heat away more easily, thereby improving the overall heat dissipation effect.

In this embodiment, the condensing apparatus 30 is disposed on the first cavity, and is configured to condense the first vapor to fall back into the first cavity when encountering with the first vapor. Specifically, the condensing apparatus 30 is any apparatus with a condensing function, and an implementation structure of the condensing apparatus 30 is not limited. Optionally, an inner side of the condensation end 23 adopts a finned structure, and/or the condensing apparatus 30 adopts the finned structure, where the finned structure includes a plurality of vertically downward condensing channels, and the inner side of the condensation end 23 refers to a side of the condensation end 23 that faces the interior of the first cavity. The finned structure includes a plurality of fins, and every two adjacent fins forms one of the condensing channels. The finned structure increases a heat exchange surface area, thereby improving an overall heat dissipation effect of the passive liquid cooling system 100.

It should be understood that, when the first vapor rises and comes into contact with the condensing apparatus 30, the condensing apparatus 30 condenses the first vapor, and the resulting condensed liquid falls back into the first cavity. The condensed liquid that falls back exchanges heat with the first liquid in the first cavity, to further cool the first liquid in the first cavity, thereby providing a reliable guarantee for better heat dissipation from the heat-generating component.

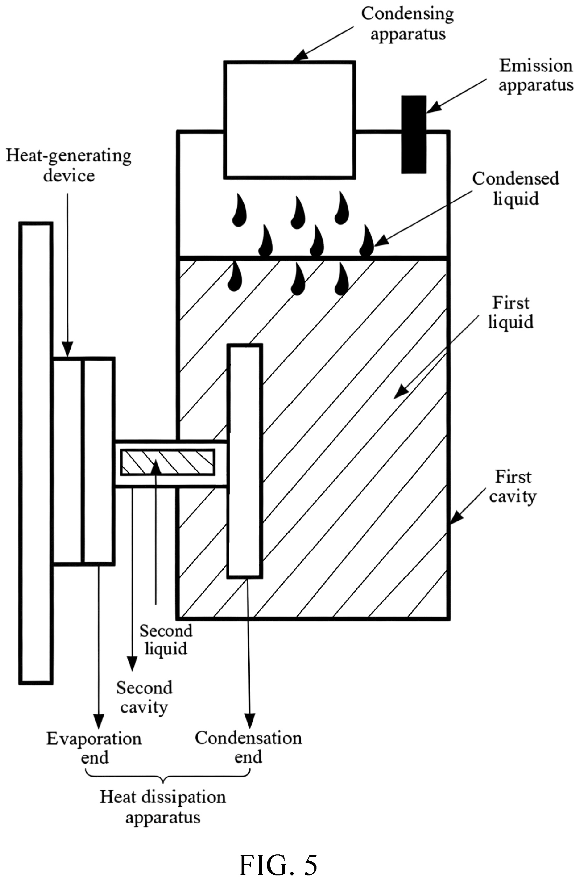

In this embodiment of the present disclosure, a disposition location and a disposition manner of the condensing apparatus on the first cavity are not limited. In an optional embodiment, the condensing apparatus 30 is disposed through a top region of the first cavity. To be specific, a part of the condensing apparatus 30 is inside the first cavity, and the condensing apparatus 30 extends outward from an interior of the first cavity to an exterior of the first cavity through the top region of the first cavity. FIG. 4 and FIG. 5 are shown by using an example in which the condensing apparatus 30 is disposed through the top region of the first cavity. In another optional implementation, the condensing apparatus 30 is disposed inside the first cavity. In other words, the entire condensing apparatus 30 is entirely located inside the first cavity. For example, the condensing apparatus 30 is disposed below the top region of the first cavity and is fixed to a first top region. In still another optional embodiment, the condensing apparatus 30 is alternatively implemented as the top region of the first cavity. In other words, the top region of the first cavity is implemented by using a condensing material to directly serve as the condensing apparatus 30. In still another optional embodiment, the condensing apparatus 30 includes a first part and a second part. The first part is disposed on the first cavity, and the second part is disposed outside the first cavity and is connected with the first part. For example, the condensing apparatus 30 is implemented as a structure having an I-shape, where one horizontal part of the I-shape is disposed at the top region of the first cavity, the other horizontal part of the I-shape is located outside the first cavity, and the two horizontal parts are connected by a middle vertical part. Optionally, the first part and the second part of the condensing apparatus 30 are integrally formed, which is not limited herein.

Referring to FIG. 4, optionally, an emission apparatus 40 is further disposed on the first cavity of the passive liquid cooling system 100, and is configured to emit the first vapor outward when air pressure in the first cavity is greater than a safe pressure value.

Specifically, the emission apparatus 40 is any device with an emission function, for example, the emission apparatus 40 is an emission valve. The emission valve includes an air inlet and an air outlet. The air inlet communicates with the first cavity and is configured to admit the first vapor, and the air outlet communicates with external air and is configured to emit the first vapor outward. A mounting location of the emission apparatus 40 is not limited. Preferably, the emission apparatus 40 is disposed at the top of the first cavity, or disposed at a first location on the side wall of the first cavity, and the first location is higher than the liquid level of the first liquid.

To better understand the new passive liquid cooling system 100 provided in the embodiments of the present disclosure, descriptions are provided with reference to a diagram of an application scenario shown in FIG. 5. First, the heat-generating component is in contact with the evaporation end 22 of the heat dissipation apparatus 20 in the passive liquid cooling system 100. The evaporation end 22 absorbs the heat from the heat-generating component. The heat absorbed by the evaporation end 22 is conducted to the second liquid in the second cavity. The second liquid in the second cavity undergoes the phase transition and turns into the second vapor. The second vapor encounters with the condensation end 23 in the heat dissipation apparatus 20, and becomes condensed liquid and falls back into the second cavity again. Because the condensation end 23 is immersed in the first liquid, the heat absorbed by the condensation end 23 is conducted to the first liquid in the first cavity. After absorbing the heat, the first liquid undergoes the phase transition and turns into the first vapor. The first vapor rises and encounters with the condensing apparatus 30 to become the condensed liquid, and then falls back into the first cavity. In an actual application, the air pressure of the first cavity is high. In this case, the emission apparatus 40 emits air outward to reduce the air pressure of the first cavity, thereby ensuring the service life and service reliability of the passive liquid cooling system 100.

This embodiment of the present disclosure provides a new passive liquid cooling system 100. The passive liquid cooling system 100 belongs to the liquid cooling technology in a large technical scope, but different from a conventional cold-plate liquid cooling solution and a conventional immersion liquid cooling solution, the passive liquid cooling system 100 is an entirely new liquid cooling solution. The passive liquid cooling system 100 provided in this embodiment of the present disclosure is an indirect-contact heat dissipation solution that does not rely on a circulation pump, and in addition, is also a solution that performs heat dissipation through two-layer (or two-stage) liquid phase transition. Because the system does not rely on the circulation pump, various technical problems caused by the circulation pump are resolved. For example, the entire passive liquid cooling system 100 is not limited by a service life of the circulation pump, eliminating a need to perform operation and maintenance on the circulation pump. Deployment and implementation also do not rely on an overall planning of an IDC, making implementation straightforward and enabling comprehensive rollout and implementation of the passive liquid cooling system in various equipment rooms. In addition, the two-layer liquid phase transition is used for heat dissipation, featuring high heat dissipation performance, so that a heat dissipation requirement of a high-power device can be satisfied. For example, the passive liquid cooling system 100 is applicable to performing heat dissipation on various exchange chips with large exchange capacities, such as a 51.2 T exchange chip. Moreover, because of indirect-contact heat dissipation, a chip or a device is not immersed in the liquid any more, which not only addresses problems caused by the circulation pump and the heat dissipation requirement of the high-power device, but also addresses a problem of liquid interference with an electrical signal or an optical signal, making the passive liquid cooling system 100 universally applicable. The passive liquid cooling system 100 provided in this embodiment of the present disclosure is applicable to heat dissipation for various chips including an optical signal module and some future chips that includes an optical signal module.

An embodiment of the present disclosure further provides a board, the board includes a chip, at least one of the board and the chip is mounted with the passive liquid cooling system provided in the embodiments of the present disclosure. The board is an embedded board having different chip architectures, or different central processing units, or different board hardware configurations, which is not limited herein. For example, the board includes, but is not limited to including, a central processing unit chip, a memory chip, a graphics processing unit (graphics processing unit, GPU for short) chip, and an exchange chip. The exchange chip is a chip with exchange and control functions, and is implemented by using a field programmable gate array (Field Programmable Gate Array, FPGA). Optionally, the board and/or the chip is detachably connected with the passive liquid cooling system , thereby improving flexibility of mounting and removal of the passive liquid cooling system. According to different application requirements, the passive liquid cooling system is directly mounted on the board, or the passive liquid cooling system is mounted on a chip requiring cooling on the board. Optionally, the board and a specific chip both are mounted with the passive liquid cooling system, to implement dual cooling, thereby further improving a cooling effect. In this embodiment of the present disclosure, a mounting manner between the board or the chip and the passive liquid cooling system is not limited. For example, the board or the chip is fixedly mounted in a manner of screws and nuts, snap-fit, or the like.

An embodiment of the present disclosure further provides an electronic device, the electronic device including a board. The board includes a chip. At least one of the electronic device, the board, and the chip is mounted with the passive liquid cooling system provided in the embodiments of the present disclosure.

In daily operation and maintenance of a data center, a heat dissipation task of an exchange chip is one of important tasks. The new passive liquid cooling system is used to dissipate heat from the exchange chip. The new passive liquid cooling system involves indirect-contact liquid cooling heat dissipation and utilizes phase transition of a coolant with a low boiling point for heat exchange, which eliminates a need for a circulation pump and liquid replenishment, facilitating and simplifying operation, maintenance, and deployment of liquid cooling, thereby reducing operation and maintenance complexity. In addition, the exchange chip does not need to be immersed in liquid, which does not affect transmission of an optical signal of an optical module on the exchange chip. The liquid is sealed, so that leakage does not occur, thereby improving security of the data center.

In an actual application, the data center experiences both peak load and off-peak load all year round. When the data center is under the peak load, that is, when load pressure of the data center is high, exchange chips in each equipment room in the data center have high power consumption, and generate a large amount of heat. In this case, the passive liquid cooling system is detachably connected with the exchange chips in the data center, to efficiently dissipate the heat from the exchange chips in the data center, thereby ensuring operation security of the data center. When the data center is under the off-peak load, that is, when the load pressure of the data center is small, the exchange chips in each equipment room in the data center have low power consumption, and generate a small amount of heat. In this case, the passive liquid cooling system is detached from the exchange chips in the data center, to reduce a power consumption level of the data center.

It is noted herein that, in the foregoing embodiments of the present disclosure, the heat dissipation apparatus employs a liquid-phase structure but is not limited thereto. In some embodiments, the heat dissipation apparatus is alternatively implemented as a physical heat dissipation structure, for example, is a physical metal block structure, for example, a metal block with a good heat dissipation property like a copper block or an aluminum block.

It should be further noted that the terms "include", "comprise", or any variants thereof are intended to cover a non-exclusive inclusion. Therefore, a process, method, article, or device that includes a series of elements not only includes such elements, but also includes other elements not specified expressly, or includes inherent elements of the process, method, article, or device. Unless otherwise specified, an element limited by "include a/an..." does not exclude other same elements existing in the process, the method, the article, or the device that includes the element.

The foregoing descriptions are embodiments of the present disclosure, and are not intended to limit the present disclosure. For a person skilled in the art, various modifications and variations are made to the present disclosure. Any modification, equivalent replacement, or improvement made without departing from the spirit and principle of the present disclosure shall fall within the scope of the claims of the present disclosure.

## Claims

1. A passive liquid cooling system, comprising:
a first cavity, filled with first liquid capable of phase transition;
a heat dissipation apparatus, disposed through the first cavity, wherein the heat dissipation apparatus comprises: a second cavity, an evaporation end and a condensation end, the evaporation end and the condensation end communicate with the second cavity, and the second cavity is filled with second liquid capable of phase transition;
wherein an outer side of the evaporation end is configured to contact a heat-generating component, and cause the second liquid to undergo phase transition into second vapor when absorbing heat; and an outer side of the condensation end is in contact with the first liquid, and is configured to diffuse heat into the first liquid to cause the first liquid to undergo phase transition into first vapor, and cause the second vapor to be condensed to fall back into the second cavity when encountering with the second vapor; and
a condensing apparatus, disposed on the first cavity, and configured to condense the first vapor to fall back into the first cavity when encountering with the first vapor.

2. The passive liquid cooling system according to claim 1, wherein the heat dissipation apparatus is disposed on a side wall of the first cavity, or disposed at a bottom of the first cavity.

3. The passive liquid cooling system according to claim 2, wherein the heat dissipation apparatus is disposed in a middle region of the side wall of the first cavity, or in a lower region of the side wall of the first cavity.

4. The passive liquid cooling system according to claim 2, wherein when the heat dissipation apparatus is disposed on the side wall of the first cavity, the second cavity has a hollow rectangular cavity structure.

5. The passive liquid cooling system according to claim 1, wherein an emission apparatus is further disposed on the first cavity, and is configured to emit the first vapor outward when air pressure in the first cavity is greater than a safe pressure value.

6. The passive liquid cooling system according to claim 5, wherein the emission apparatus is disposed at a top of the first cavity, or disposed at a first location on a side wall of the first cavity, and the first location is higher than a liquid level of the first liquid.

7. The passive liquid cooling system according to claim 1, wherein the first cavity is provided with a first liquid injection port, and the first liquid injection port is configured to inject the first liquid into the first cavity;
and/or
the heat dissipation apparatus further is provided with a second liquid injection port, and the second liquid injection port communicates with the second cavity and is configured to inject the second liquid into the second cavity.

8. The passive liquid cooling system according to claim 1, wherein an inner side of the condensation end adopts a finned structure, and/or the condensing apparatus adopts the finned structure, wherein the finned structure comprises a plurality of vertically downward condensing channels.

9. The passive liquid cooling system according to claim 1, wherein a boiling point of the first liquid is lower than a boiling point of the second liquid.

10. The passive liquid cooling system according to any one of claims 1 to 9, wherein a volume of the first cavity and a volume of the first liquid are determined in advance based on a type, an application scenario, and/or power of the heat-generating component employing the passive liquid cooling system.

11. The passive liquid cooling system according to any one of claims 1 to 9, wherein the condensing apparatus is disposed through a top region of the first cavity; or the condensing apparatus is disposed inside the first cavity; or the condensing apparatus is implemented as the top region of the first cavity; or the condensing apparatus comprises a first part and a second part, the first part is disposed on the first cavity, and the second part is disposed outside the first cavity and is connected with the first part.

12. A board, the board comprising a chip, at least one of the board and the chip being mounted with the passive liquid cooling system as claimed in any one of claims 1 to 11.

13. An electronic device, the electronic device comprising a board, the board comprising a chip, at least one of the electronic device, the board and the chip being mounted with the passive liquid cooling system as claimed in any one of claims 1 to 11.
